# FASCICULE DE BREVET EUROPEEN

(11) **EP 0 881 687 B1**
(45) Date de publication et mention de la délivrance du brevet: **28.06.2006**
(21) Numéro de dépôt: 98410058.6
(22) Date de dépôt: 25.05.1998
(51) Int. Cl.: H01L 29/45

(54) **Contact sur une région de type P**
Kontakt auf P-Typ Gebiet
Contact on P-type region

(30) Priorité: 30.05.1997 FR 9706904
(43) Date de publication de la demande: 02.12.1998
(73) Titulaire: STMicroelectronics S.A., 92120 Montrouge (FR)
(72) Inventeur: Furio, Cyril, 33200 Bordeaux (FR)
(74) Mandataire: de Beaumont, Michel

(56) Documents cités:
- EP-A- 0 507 454
- "Infrared photo detectors produced by cluster beam deposition of aluminum films on silicon" IBM TECHNICAL DISCLOSURE BULLETIN., vol. 34, no. 2, juillet 1991, pages 100-102, XP002054922 NEW YORK US
- PATENT ABSTRACTS OF JAPAN vol. 10, no. 65 (E-388), 14 mars 1986 & JP 60 214563 A (MITSUBISHI DENKI K.K.)
- PATENT ABSTRACTS OF JAPAN vol. 16, no. 116 (E-1181), 24 mars 1992 & JP 03 286569 A (NEC CORP), 17 décembre 1991
- K.N. TU: "Shallow and parallel silicide contacts" JOURNAL OF VACUUM SCIENCE AND TECHNOLOGY, vol. 19, no. 1, mai 1981 - juin 1981, pages 766-777, XP002054923 NEW YORK, US

## Description

La présente invention concerne la fabrication des composants semiconducteurs. Elle vise plus particulièrement la réalisation d'un contact présentant un comportement ohmique sur une région de type P faiblement dopée.

De façon classique, il est connu dans le domaine des semiconducteurs que, pour réaliser un contact ohmique entre une région semiconductrice et une métallisation, il faut que la concentration en surface de la région semiconductrice soit relativement élevée (supérieure à 10¹⁹ atomes/cm³). Ceci pose divers problèmes pour la réalisation de tels contacts, notamment sur des régions semiconductrices de type P. On considère plus particulièrement ici le cas où la région de type P à contacter constitue l'anode d'un composant semiconducteur unidirectionnel, c'est-à-dire d'un composant bloquant le passage d'un courant quand la région de type P est polarisée négativement et permettant le passage d'un courant quand la région de type P est polarisée positivement, ce passage d'un courant en polarisation positive (polarisation directe) étant éventuellement soumis à l'application d'un courant de commande ou d'une tension dépassant un seuil déterminé.

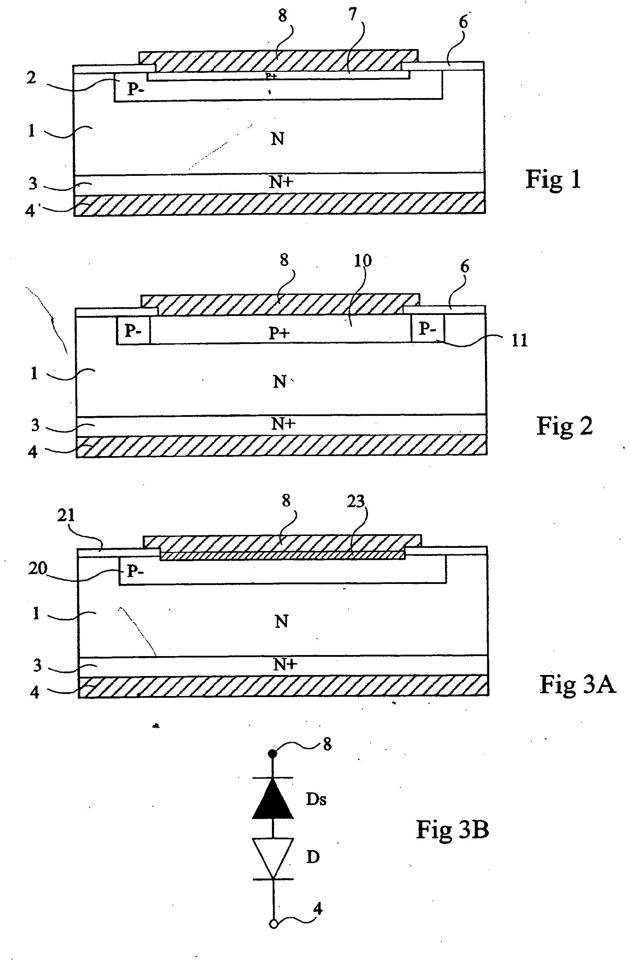

Pour exposer le problème posé, on va considérer en relation avec les figures 1 et 2 la structure d'une diode de redressement haute tension, c'est-à-dire d'une diode susceptible de supporter une tension relativement élevée en polarisation inverse.

La figure 1 représente un exemple d'une première structure classique de diode haute tension. Cette diode comporte une zone centrale 1 de type N et comprend du côté de sa face supérieure une région faiblement dopée 2 de type P (P⁻). La jonction PN 1-2 constituant la jonction de la diode considérée. Pour assurer une tenue en tension suffisante, la diode est de type planar, c'est-à-dire que la région P- est formée dans une partie seulement de la surface supérieure de la zone centrale et est complètement entourée à sa périphérie d'une région N correspondant à la zone centrale.

Pour établir un contact sur la face arrière de la diode, la face inférieure de la zone centrale comprend une couche 3 de type N⁺ fortement dopée revêtue d'une métallisation de cathode 4. Pour prendre un contact sur la face supérieure de la diode, cette face supérieure est recouverte d'une région 6 d'un isolant, couramment de l'oxyde de silicium, qui s'étend partiellement au-dessus de la région 2, une région centrale de la couche 2 étant dégagée. Dans cette région centrale, on réalise un surdopage en surface en formant une région 7 plus fortement dopée de type P (P⁺) recouverte d'une métallisation d'anode 8.

La figure 2 représente un autre exemple classique de diode haute tension. Le côté cathode comprenant la zone centrale 1, la région surdopée 3 et la métallisation de cathode 4, est inchangé par rapport à la figure 1. Du côté anode, la métallisation d'anode 8 repose sur une région 10 fortement dopée de type P entourée d'un anneau 11 de type P⁻. La jonction PN 1-10 constitue cette fois-ci la jonction de la diode considérée. Comme précédemment, on retrouve également en surface une couche d'oxyde 6 recouvrant la périphérie de la région 10.

Dans le cas des figures 1 et 2, on a réalisé un contact ohmique en formant une métallisation directement sur une région de type P fortement dopée. On considère généralement que le niveau de dopage en surface de la région P doit être supérieur à 5.10¹⁸ atomes/cm³. En outre, la périphérie de la région fortement dopée de type P est entourée d'une région de type P faiblement dopée pour améliorer la tenue en tension de la diode en inverse.

Bien entendu, diverses variantes des structures illustrées en figures 1 et 2 sont connues dans la technique. Pour améliorer la tenue en tension, on utilise par exemple, pour étaler au mieux la charge d'espace déployée par la jonction polarisée en inverse, des anneaux de garde supplémentaires de type P faiblement dopés, et/ou des plaques de champ à la périphérie de la région de type P⁻ (2, 11) et séparées du semiconducteur par une couche d'oxyde. On trouve aussi des régions de type N⁺, couramment appelées couche d'arrêt, qui viennent bloquer les lignes de potentiel susceptibles de s'étendre au-delà de la région de type P⁻ (2, 11) sous polarisation inverse, permettant ainsi d'éviter l'apparition d'un courant de fuite de canal.

D'autre part, pour réaliser un contact ohmique, on trouve toujours une région de type P fortement dopée mais cette région n'est pas nécessairement directement recouverte d'une métallisation unique. De façon courante, les métallisations d'anode ou de cathode 4 à 8 sont constituées d'une couche d'aluminium mais d'autres métaux sont également utilisés de façon classique (TiNiAu, Molybdène). On prévoit aussi des empilements, de couches métalliques et/ou d'alliages, incorporant éventuellement du silicium. Eventuellement, il est prévu une interface de siliciure (IrSi, PtSi, NiSi, ...) formé par réaction chimique solide-solide entre le silicium et le métal qui a été préalablement pulvérisé. Ceux-ci sont largement préférés aux contacts classiques métal-semiconducteur de part leurs hautes stabilités thermique et chimique.

Le fait que la couche d'anode soit constituée d'une région de type P fortement dopée en contact direct avec une région de type N faiblement dopée (figure 2) ou en contact avec une région de type P faiblement dopée elle-même en contact avec une région de type N faiblement dopée (figure 1) présente divers inconvénients.

Le premier inconvénient réside dans la nécessité de prévoir une couche de type P fortement dopée et une couche de type P faiblement dopée à la périphérie. Ceci nécessite la prévision de plusieurs étapes de masquage et complique le procédé de fabrication.

Un autre inconvénient réside dans le fait même de devoir prévoir une couche de type P fortement dopée, ce qui implique la nécessité de prévoir une étape de recuit à relativement haute température et de relativement longue durée, par exemple supérieure à 1150°C pendant plusieurs heures, ce qui occupe du temps de fabrication et nuit à la qualité cristalline du silicium.

Enfin et surtout, dans le cas où l'on veut réaliser une diode ou autre composant rapide dont la couche P constitue l'anode, la présence de la couche P fortement dopée dégrade les performances dynamiques du composant comprenant cette couche P comme anode. En effet, lorsque la tension appliquée à la diode est inversée, la diode doit normalement passer de l'état passant à l'état bloqué. Mais il est bien connu qu'il s'écoule un certain temps avant que la diode ne retrouve son pouvoir de blocage. Ce temps, couramment appelé temps de recouvrement, est celui que nécessite l'évacuation des porteurs encore stockés dans la zone centrale 1, porteurs préalablement injectés par la région d'anode pendant le fonctionnement à l'état passant. Cette injection de porteurs est d'autant plus élevée que la région de type P est plus fortement dopée. Ainsi, la vitesse de commutation à l'ouverture de la diode est limitée par la présence d'une région de type P fortement dopée. Pour pallier cet inconvénient, on a prévu dans l'art antérieur la création de défauts dans la zone centrale et notamment au voisinage de la jonction PN de la diode, par exemple en réalisant une diffusion de métaux tels que de l'or ou du platine ou par bombardement électronique ou protonique ou autre. Toutefois, ce remède entraîne d'autres inconvénients et notamment augmente la chute de tension en direct de la diode.

Ainsi, un objet de la présente invention est de pallier les défauts susmentionnés de composants unidirectionnels tels que des diodes ou thyristors ou même de composants tels que des transistors bipolaires destinés à fonctionner dans un mode unidirectionnel pour améliorer le temps de recouvrement, c'est-à-dire le temps de commutation à l'ouverture.

Dans ce but, la présente invention prévoit une structure de prise de contact permettant de prendre directement un contact de type ohmique sur une couche de type P faiblement dopée destinée à servir d'anode d'un composant unidirectionnel.

Plus particulièrement, la présente invention prévoit une structure de prise de contact sur une région de type P faiblement dopée d'un composant semiconducteur, cette région de type P étant destinée à être polarisée positivement lors du fonctionnement à l'état passant dudit composant, comprenant sur ladite région P une couche de siliciure de platine, ou de siliciure d'un métal présentant avec le silicium de type P une hauteur de barrière inférieure ou égale à celle du siliciure de platine.

Selon un mode de réalisation de la présente invention, le siliciure est un siliciure d'iridium.

Selon un mode de réalisation de la présente invention, la région de type P a un niveau de dopage en surface de l'ordre de 10¹⁵ à 10¹⁶ atomes/cm³.

Selon un mode de réalisation de la présente invention, la périphérie de la région de type P faiblement dopée est recouverte d'une couche d'oxyde.

Selon un mode de réalisation de la présente invention, la région de type P est formée dans une portion de la surface supérieure d'une région de type N.

Selon un mode de réalisation de la présente invention, ladite région P constitue l'anode d'une diode.

Selon un mode de réalisation de la présente invention, ladite région P constitue l'anode d'un thyristor.

Selon un mode de réalisation de la présente invention, ladite région P constitue la gâchette d'un thyristor.

Selon un mode de réalisation de la présente invention, ladite région P constitue le collecteur d'un transistor bipolaire de type PNP.

Selon un mode de réalisation de la présente invention, le composant dont ladite région de type P constitue une anode est un composant vertical.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 représentent des structures de diodes selon l'art antérieur ;
la figure 3A représente un mode de réalisation de la présente invention appliquée à une diode rapide haute tension ;
la figure 3B représente un schéma équivalent de la structure de la figure 3A ;
la figure 4 représente de façon simplifiée la caractéristique de deux types de diode Schottky en direct et en inverse ;
la figure 5 représente une courbe de courant en fonction du temps illustrant les caractéristiques dynamiques d'une diode selon la présente invention et d'une diode selon l'art antérieur ; et
la figure 6 représente une structure de thyristor à laquelle est appliquée la présente invention.

Comme cela est classique dans le domaine de la représentation des composants semiconducteurs, les diverses vues en coupe sont fortement schématiques et ne sont pas tracées à l'échelle. L'homme de l'art saura choisir l'épaisseur de la zone centrale, les profondeurs de jonction et les dimensions latérales des composants en fonction des performances de tenue en tension et de puissance qu'il recherche.

La figure 3A est une vue en coupe schématique d'une diode haute tension à laquelle s'applique la présente invention. La région de cathode de la diode comprend une zone centrale 1 de type N faiblement dopée, une région 3 de type N fortement dopée et une métallisation de cathode 4, comme dans les exemples des figures 1 et 2. La région d'anode de la diode comprend une région 20 de type P faiblement dopée (P⁻) dont la périphérie est recouverte d'une couche d'un isolant 21, par exemple de l'oxyde de silicium, pour délimiter une région centrale de prise de contact sur la région P-. Dans cette région centrale est formée une couche de siliciure de platine 23 sur laquelle est formée la métallisation d'anode 8, avec intervention éventuelle de couches servant de barrière de diffusion.

Le mode de formation d'une couche de siliciure de platine telle que la couche 23 est bien connu dans la technique, et consiste par exemple à procéder à un dépôt de platine suivi d'un recuit à une température comprise entre 500 et 600°C suivi d'une gravure sélective du platine en excès. De telles couches de siliciure sont connues en elles-mêmes et sont essentiellement utilisées pour la réalisation de diodes Schottky et pour obtenir des connexions de faible résistivité (essentiellement dans le domaine de la fabrication des circuits intégrés). Selon la présente invention, la couche de siliciure de platine n'est utilisée pour aucun de ces deux objets classiques (diode Schottky ou réduction de résistance de connexion) mais pour la réalisation d'un contact ohmique.

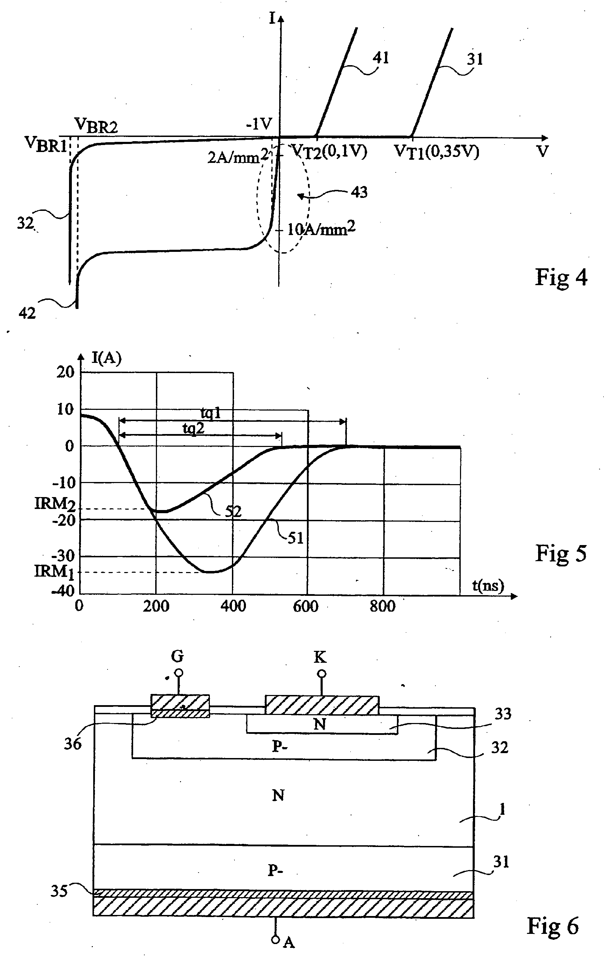

La figure 3B représente un schéma équivalent du circuit de la figure 3A. Ce schéma équivalent comprend, entre une borne d'anode 8 et une borne de cathode 4, une diode bipolaire D correspondant à la jonction PN entre la région 20 et la zone centrale 1, et une diode Schottky DS, disposée tête-bêche vis à vis de la diode bipolaire D, correspondant à l'interface entre la région de siliciure de platine 23 et la région 20. Une telle structure permet d'obtenir un contact présentant un comportement de type ohmique dans le cas où la diode D est susceptible de conduire (application d'une tension positive sur l'anode 8), c'est-à-dire quand elle est polarisée en direct et que la diode Schottky DS est en inverse. Ceci va être expliqué en relation avec la figure 4.

La figure 4 représente la caractéristique directe 31 et la caractéristique inverse 32 d'une diode Schottky classique. Les courbes 41 et 42 représentent les caractéristiques directe et inverse, respectivement, d'une diode Schottky constituée de l'interface entre une région de siliciure de platine et une région de type P faiblement dopée. En figure 4, l'échelle des tensions et des courants n'est pas la même dans le quadrant de fonctionnement en direct (courbes 31 et 41) et dans le quadrant de fonctionnement en inverse (courbes 32 et 42) des diodes Schottky.

Les courbes 31 et 32 illustrent la caractéristique d'une diode Schottky classique, par exemple une diode Schottky constituée d'un siliciure de titane (TiSi₂) formé sur une région de type P faiblement dopée.

La caractéristique directe, 31, c'est-à-dire la caractéristique d'une diode Schottky où la couche P- sert d'anode et la couche de siliciure de cathode est une caractéristique classique de diode en direct. Le courant reste sensiblement nul jusqu'à ce que la tension aux bornes de la diode atteigne la tension de seuil de mise en conduction de cette diode V_{T1}, par exemple une tension de l'ordre de 0,35 volt puis, quand la tension dépasse la valeur de 0,35 volt, la chute de tension aux bornes de la diode est essentiellement contrôlée par la chute de tension ohmique due aux résistances série de la structure.

En polarisation inverse, on obtient la caractéristique illustrée par la courbe 32. La diode bloque sensiblement tout passage de courant en inverse jusqu'à une tension de claquage VBR1, par exemple de l'ordre de 50 V.

Dans le cas d'une diode Schottky réalisée entre du silicium de type P faiblement dopée et un siliciure de platine, la caractéristique en direct, 41, est peu différente dans son allure de la caractéristique en direct 31 précédemment décrite. La différence essentielle est que la tension de seuil de mise en conduction V_{T2} est plus faible que V_{T1}, par exemple de l'ordre de 0,1 volt et non pas de 0,35 volt ou plus. Mais surtout, l'allure de la caractéristique en inverse 42 est fortement modifiée. Dans une zone initiale 43 d'application de tension inverse, cette caractéristique est sensiblement celle d'une résistance de très faible valeur. En effet, lorsque l'on fait passer une densité de courant de 2 A/mm², régime de fonctionnement typique d'une diode haute tension, la chute de tension aux bornes de la diode est inférieure à 100 mV. Et tant que l'on tend à faire passer une densité de courant inférieure à une valeur de l'ordre de 10 A/mm², la chute de tension aux bornes de la diode reste très faible (de l'ordre de 1 volt).

C'est l'utilisation de cette portion 43 de la caractéristique inverse d'une diode Schottky formée entre une région de type P faiblement dopée et un siliciure de platine que la présente invention met en oeuvre pour réaliser un contact de type ohmique sur une région de type P faiblement dopée. Il est clair que la présente invention se limite au cas où la région de type P est utilisée en tant qu'anode d'un composant, c'est-à-dire au cas dans lequel la diode Schottky est polarisée en inverse.

On notera que ceci se différencie complètement d'un cas classique dans lequel on utilise la même diode Schottky tantôt en inverse, tantôt en direct en négligeant la faible chute de tension en direct de l'ordre de 0,1 volt. En effet, dans le sens direct, il n'y a plus de comportement de type ohmique mais seulement un comportement non-ohmique à faible chute de tension. Cela signifie qu'il s'ajoute aux pertes ohmiques une consommation de puissance qui sera par exemple de 1 W/mm² pour un courant de 10 A/mm² dans la diode.

La figure 5 illustre l'amélioration apportée aux caractéristiques dynamiques d'une diode par le procédé selon la présente invention.

Cette figure représente des courbes de courant en ampère en fonction du temps en nanoseconde. Dans ces courbes, l'instant zéro correspond à l'instant où la tension appliquée à la diode, initialement à l'état passant, est inversée. Ainsi, initialement, il passait un courant légèrement inférieur à 10 ampères dans la diode. Ensuite, ce courant diminue rapidement puis s'inverse, c'est-à-dire que la diode est temporairement passante en inverse avant de revenir à l'état bloqué pour lequel le courant est égal à zéro. Il est clair que l'on cherche en pratique à réduire autant que possible ce passage en conduction inverse de la diode. On désigne généralement par la référence I_{RM} le pic de courant inverse et l'on appelle temps de recouvrement, désigné par la référence t_{q}, l'intervalle de temps entre les deux passages à zéro de la courbe.

En figure 5, la courbe désignée par la référence 51 correspond à une diode de puissance haute tension classique telle que celle de la figure 2 et la courbe 52 correspond à une diode de même dimension conforme à l'invention, du type illustré en figure 3A. Le pic de courant inverse IRM₁ de la diode classique est de l'ordre de 35 ampères alors que le pic de courant inverse IRM₂ est inférieur à 20 A. Le temps de recouvrement t_{q1} de la diode classique est de l'ordre de 550 nanosecondes alors que le temps de recouvrement t_{q2} de la diode selon la présente invention est seulement de l'ordre de 390 nanosecondes. Il est donc clair que la diode selon la présente invention présente un comportement dynamique considérablement amélioré par rapport à une diode à prise de contact d'anode classique sur une région de type P⁺.

La présente invention est susceptible de nombreuses variantes et modifications qui apparaîtront à l'homme de l'art.

D'une part, les améliorations classiquement apportées aux diodes décrites en relation avec l'art antérieur pourront également s'appliquer à la présente invention pour améliorer les caractéristiques de tenue en tension inverse et de courant de fuite.

D'autre part, bien que la présente invention n'ait été décrite que dans le cas où la couche de prise de contact sur une région de type P⁻ est en siliciure de platine, il apparaîtra clairement à l'homme de l'art que tout siliciure équivalent pourra être adopté. La condition est que la hauteur de barrière Schottky sur la région de type P⁻ soit inférieure ou égale à une valeur de l'ordre de 0,3 volt (on a alors le même type de comportement en inverse). C'est par exemple le cas d'un siliciure d'iridium dont la hauteur de barrière Schottky est de l'ordre de 0,19 volt. On obtient alors une caractéristique inverse du type de celle illustrée par la courbe 42 comprenant une région 43 où le comportement en inverse est de type ohmique avec une valeur de résistance très faible.

Par ailleurs, la présente invention a été décrite dans le cadre de son application à une diode de puissance haute tension. Il est clair qu'elle s'applique de façon générale à tout dispositif dans lequel on souhaite établir un contact sur une région de type P faiblement dopée, et destinée à fonctionner en anode. La suppression d'une couche P⁺ permet de limiter le phénomène d'injection de porteurs et améliore le temps de recouvrement à la commutation à l'ouverture. Ceci est notamment utile pour l'anode d'un thyristor ou composant équivalent ou pour le collecteur d'un transistor de type PNP (ceci ne s'applique pas à l'émetteur destiné au contraire à fonctionner en cathode).

A titre d'exemple, la figure 6 représente un thyristor pour lequel la présente invention a été mise en oeuvre. Ce thyristor comprend une zone centrale 1 de type N. Du côté de la face arrière est formée une couche d'anode 31 de type P, et du côté de la face avant est formée une région de gâchette 32 de type P. De préférence, les couches 31 et 32 sont formées simultanément. Une région de cathode 33 de type fortement dopée est formée dans la région 32. Une métallisation de cathode K est formée de façon classique sur la région de cathode K.

Selon l'invention, les régions P 31 et 32 sont moyennement dopées et des contacts d'anode A et de gâchette G sont pris par l'intermédiaire de couches de siliciure de platine 35 et 36. L'avantage essentiel de disposer d'une couche d'anode 31 moyennement dopée est d'améliorer la vitesse de commutation à l'ouverture. L'avantage essentiel de disposer d'une couche de gâchette 32 moyennement dopée est d'éviter de savoir utiliser un anneau de garde de type P pour des thyristors haute tension. Bien entendu, un avantage supplémentaire réside dans la réduction du nombre d'étapes d'implantation/diffusion.

De plus, la présente invention a été décrite ci-dessus dans le cadre de son application à un composant isolé (diode, thyristor, transistor PNP...). Elle s'appliquera aussi dans le cas où plusieurs composants, soit éventuellement plusieurs composants verticaux, sont formés sur une même puce. Plusieurs régions de siliciure de platine pourront alors être formées simultanément, une ou plusieurs de ces régions ayant la fonction utilisée selon l'invention (prise de contact ohmique sur une région d'anode de type P faiblement dopée), et une ou plusieurs de ces régions ayant une fonction classique (formation d'une diode Schottky, réduction de la résistivité de connexion).

## Revendications

1. Dispositif semiconducteur comprenant un contact présentant un comportement ohmique sur une région de type P ayant un niveau de dopage en surface de l'ordre de 10¹⁵ à 10¹⁶ atomes/cm³ et destinée a fonctionner en anode, **caractérisé en ce qu'**il comprend sur ladite région P (20) une couche d'un siliciure de platine (23), ou d'un siliciure de métal présentant avec le silicium de type P une hauteur de barrière de Schottky inférieure ou égale à celle du siliciure de platine.

2. Dispositif semiconducteur selon la revendication 1, dans lequel le siliciure est un siliciure d'iridium.

3. Dispositif semiconducteur selon la revendication 1 ou 2, dans lequel la périphérie de la région de type P faiblement dopée est recouverte d'une couche d'oxyde (21).

4. Dispositif semiconducteur selon l'une quelconque des revendications 1 à 3,dans lequel la région de type P est formée dans une portion de la surface supérieure d'une région de type N (1).

5. Dispositif semiconducteur selon la revendication 4, dans lequel ladite région P constitue l'anode d'une diode.

6. Dispositif semiconducteur selon la revendication 1, dans lequel ladite région P constitue l'anode ou la gâchette d'un thyristor.

7. Dispositif semiconducteur selon la revendication 1, dans lequel ladite région P constitue la gâchette d'un thyristor.

8. Dispositif semiconducteur selon la revendication 1, dans lequel ladite région P constitue le collecteur, d'un transistor bipolaire de type PNP.

9. Dispositif semiconducteur selon l'une quelconque des revendications 5 à 8, dans lequel le composant dont ladite région de type P constitue une anode est un composant vertical.

## Claims

1. A semiconductor device comprising a contact having ohmic properties on a lightly-doped P-type region having a surface doping level on the order of 10¹⁵ to 10¹⁶ atoms/cm³ and adapted to operate as an anode, **characterized in that** it includes on said P region (20) a layer of platinum silicide (23), or of a metal silicide having with the P-type silicon a barrier height lower than or equal to that of the platinum silicide.

2. The semiconductor device of claim 1, wherein the silicide is an iridium silicide.

3. The semiconductor device of claim 1 or 2, wherein the periphery of the lightly-doped P-type region is covered with an oxide layer (21).

4. The semiconductor device of any of claims 1 to 3, wherein the P-type region is formed in a portion of the upper surface of an N-type region (1).

5. The semiconductor device of claim 4, wherein the P region forms the anode of a diode.

6. The semiconductor device of claim 1, wherein the P region forms the anode or the gate of a thyristor.

7. The semiconductor device of claim 1, wherein the P region forms the gate of a thyristor.

8. The semiconductor device of claim 1, wherein the P region forms the collector of a PNP-type bipolar transistor.

9. The semiconductor device of any of claims 5 to 8, wherein the component, the P-type region of which forms an anode, is a vertical component.

## Patentansprüche

1. Halbleitervorrichtung mit einem ein ohmsches Verhalten zeigenden Kontakt auf einem Bereich vom P-Leitfähigkeitstyp, der einen Dotierungspegel an der Oberfläche in der Größenordnung von 10¹⁵ bis 10¹⁶ Atome/cm³ aufweist und zur Funktion als Anode bestimmt ist, **dadurch gekennzeichnet dass** die Vorrichtung auf dem genannten P-Bereich (20) eine Schicht (23) aus einem Platinsilizid oder aus einem Metallsilizid aufweist, das mit dem P-Typ-Silizium eine Höhe der Schottky-Battier- Schwelle kleiner oder gleich der des Platinsilizids besitzt.

2. Halbleitervorrichtung nach Anspruch 1, bei welcher das Silizid ein Iridium-Silizid ist.

3. Halbleitervorrichtung nach Anspruch 1 oder 2, bei welcher der Umfang des schwach dotierten Bereichs vom P- Leitfähigkeitstyp mit einer Oxydschicht (21) überzogen ist.

4. Halbleitervorrichtung nach einem der Ansprüche 1 bis 3, bei welcher der Bereich vom P-Leitfähigkeitstyp in einem Teil der Oberseite eines Bereichs (1) vom N-Leitfähigkeitstyp ausgebildet ist.

5. Halbleitervorrichtung nach Anspruch 4, bei welcher der genannte P-Bereich die Anode einer Diode bildet.

6. Halbleitervorrichtung nach Anspruch 1, bei welcher der genannte P-Bereich die Anode oder das Gate eines Thyristors bildet.

7. Halbleitetvorrichtung nach Anspruch 1, bei welcher der genannte P-Beieich das Gate eines Thyristors bildet.

8. Halbleitervortichtung nach Anspruch 1, bei welcher der genannte P-Bereich den Kollektor eines bipolaren Transistors vpm PNP-Typ bildet.

9. Halbleitervorrichtung nach einem der Ansprüche 5 bis 8, bei welcher das Bauteil, dessen genannter Bereich vom P-Leitfähigkeitstyp eine Anode bildet, ein vertikales Bauteil ist.
